# EUROPEAN PATENT APPLICATION

(11) **EP 4 807 412 A1**
(43) Date of publication of application: **16.09.2026**
(21) Application number: 25224749.9
(22) Date of filing: 18.12.2025
(51) Int. Cl.: G02B 6/122, G02B 6/136, G02B 6/138, G02B 6/43, H10W 76/47, H10W 90/00, H10W 70/60

(54) **METHODS AND APPARATUS FOR OPTICAL CHIP-TO-CHIP COMMUNICATIONS**

(30) Priority: 10.03.2025 US 202519075148
(71) Applicant: Intel Corporation, Santa Clara, CA 95054 (US)
(72) Inventor: GEIGER, Richard, 80939 Munich (DE); HANNA, Carlton, San Jose, CA 95126 (US); HEROLD, Klaus, 81825 Munich (DE); KREBS, Tim Helmut, 81475 Munich (DE); LANGENBUCH, Michael, 81825 Munich (DE); PALANISAMY, Sidharthi, 82024 Taufkirchen (DE); RAUH, Johannes Xaver, 85614 Kirchseeon (DE); WAGNER, Thomas Helmut, 91189 Regelsbach (DE)
(74) Representative: HGF

(57) **Abstract**

Systems, apparatus, articles of manufacture, and methods for optical chip-to-chip communications are disclosed. An example apparatus includes a package substrate, and a first semiconductor die carried by the package substrate. The first semiconductor die includes a first waveguide. The first waveguide includes a first end associated with a first exterior surface of the first semiconductor die. The example apparatus further includes a second semiconductor die carried by the package substrate. The second waveguide includes a second end associated with a second exterior of the second semiconductor die. The second waveguide is optically coupled to the first waveguide.

## Description

### BACKGROUND

As technology advances, transistors and other features within integrated circuits continue to be fabricated at smaller sizes and/or at higher densities. In recent years, to improve yield and performance in view of the higher transistor densities, many integrated circuit packages (e.g., microprocessors) have been fabricated with multiple disaggregated semiconductor dies or chiplets.

### BRIEF DESCRIPTION OF THE DRAWINGS

FIG. 1 illustrates an example integrated circuit (IC) package constructed in accordance with teachings disclosed herein.
FIGS. 2-4 illustrate an example assembly representing a first example implementation of the optical coupling of the first and second dies of FIG. 1.
FIGS. 5-7 illustrate another example assembly representing a second example implementation of the optical coupling of the first and second dies of FIG. 1.
FIGS. 8-10 illustrate another example assembly representing a third example implementation of the optical coupling of the first and second dies of FIG. 1.
FIGS. 11-14 illustrate different stages in an example process to manufacture the example assembly of FIGS. 2-4.
FIGS. 15-17 illustrate different stages in an example process to manufacture the example assembly of FIGS. 5-7.
FIGS. 18-21 illustrate different stages in an example process to manufacture the example assembly of FIGS. 8-10.
FIG. 22 illustrates an example assembly 2200 representing a fourth example implementation of the optical coupling of the first and second dies 108, 110 of FIG. 1.
FIG. 23 is a top view of a wafer including dies that may be included in an IC package constructed in accordance with teachings disclosed herein.
FIG. 24 is a cross-sectional side view of an IC device that may be included in an IC package constructed in accordance with teachings disclosed herein.
FIG. 25 is a cross-sectional side view of an IC device assembly that may include an IC package constructed in accordance with teachings disclosed herein.
FIG. 26 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

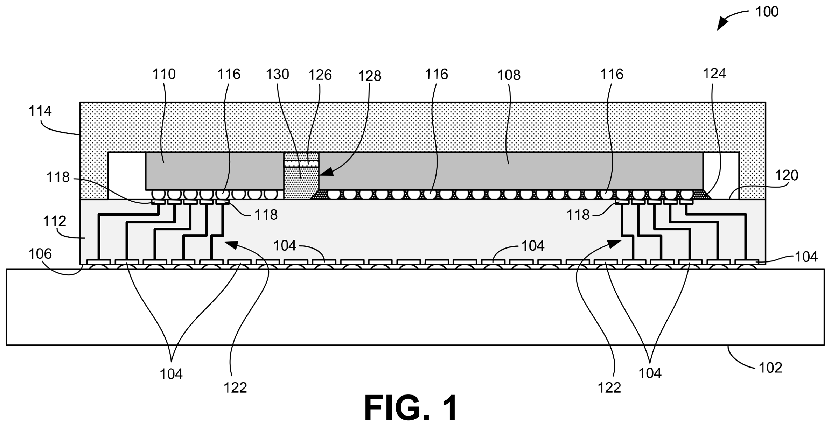

FIG. 1 illustrates an example integrated circuit (IC) package 100 constructed in accordance with teachings disclosed herein. In the illustrated example, the IC package 100 is electrically coupled to an underlying substrate 102 via an array of contacts 104 on a package mounting surface 106 (e.g., a bottom surface, an external surface) of the package. In some examples, the substrate 102 can be implemented by a printed circuit board (PCB) or a package substrate (e.g., the IC package 100 is part of another larger package). In the illustrated example, the contacts 104 are represented as pads or lands. However, in some examples, the IC package 100 may include balls, pins, and/or any other type(s) of contact, in addition to or instead of the pads or lands shown to enable the electrical coupling of the IC package 100 to the substrate 102. In this example, the package 100 includes two semiconductor dies 108, 110 (e.g., silicon dies), sometimes also referred to as chips, chiplets, or tiles, that are mounted to a package substrate 112 and enclosed by a package lid 114 (e.g., a mold compound, an integrated heat spreader (IHS)). Thus, the package substrate 112 is an example means for supporting a semiconductor die. In some examples, the package lid 114 is omitted, thereby leaving the semiconductor dies 108, 110 exposed or bare.

While the example IC package 100 of FIG. 1 includes two dies 108, 110, in other examples, the IC package 100 may have more than two dies. In some examples, multiple dies 108, 110 are implemented to reduce the size of any given die, thereby reducing yield loss, which would otherwise increase as transistor densities continue to increase. Furthermore, in some examples, multiple, disaggregated dies can also simplify the circuitry and the associated circuit design process of any given die (e.g., by designing different dies focused on a single or limited set of functions). In some cases, such disaggregated dies 108, 110 can improve system performance. In some examples, one of the dies 108, 110 (or a separate die) is embedded in the package substrate 112. The dies 108, 110 can provide any suitable type of functionality (e.g., data processing, memory storage, etc.). In some examples, one or both of the dies 108, 110 are implemented by a die package including multiple dies arranged in a stacked formation. For example, the die 110 can include a stack of Dynamic Random Access Memory (DRAM) die arranged on top of a memory controller die to form a memory die stack.

As shown in the illustrated example, each of the dies 108, 110 is electrically and mechanically coupled to the package substrate 112 via corresponding arrays of interconnects 116. In FIG. 1, the interconnects are shown as bumps. In some examples, the interconnects 116 can include solder joints, micro bumps, combinations of metallic (e.g., copper) pillars and solder, etc. In other examples, the interconnects 116 may include directly bonded or "hybrid bonded" metallic interconnects. In other examples, the interconnects 116 may be any other type of electrical connection in addition to or instead of the bumps shown (e.g., balls, pins, pads, pillars, wire bonding, etc.). The electrical connections between the dies 108, 110 and the package substrate 112 (e.g., the interconnects 116) are sometimes referred to as first level interconnects. By contrast, the electrical connections between the IC package 100 and the substrate 102 (e.g., the contacts 104) are sometimes referred to as second level interconnects. In some examples, one or both of the dies 108, 110 may be stacked on top of one or more other dies and/or an interposer. In such examples, the dies 108, 110 are coupled to the underlying die and/or interposer through a first set of first level interconnects and the underlying die and/or interposer may be connected to the package substrate 112 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 116 enable electrical signals and/or power to pass between the dies 108, 110 and components external to the IC package 100. More particularly, as shown in the illustrated example, when the dies 108, 110 are mounted to the package substrate 112, the interconnects 116 are physically connected and electrically coupled to contact pads 118 on a die mounting surface 120 (e.g., an upper surface, a top surface, etc.) of the package substrate 112. The contact pads 118 on the die mounting surface 120 of the package substrate 112 are electrically coupled to the contacts 104 on the package mounting surface 106 (e.g., the bottom, external surface) of the package substrate 112 (e.g., a surface opposite the die mounting surface 120) via internal interconnects 122 within the package substrate 112. As a result, there is a continuous electrical signal path between the interconnects 116 of the dies 108, 110 and the contacts 104 mounted to the substrate 102. Specifically, the electrical signal path passes through the contact pads 118 and the internal interconnects 122 provided between interconnects 116 of the dies 108, 11 and the contacts 104 at the substrate 102. As shown, the package mounting surface 106 and the die mounting surface 120 define opposing outer surfaces of the package substrate 112. While both surfaces are outer surfaces of the package substrate, the die mounting surface 120 is sometimes referred to herein as an internal or inner surface relative to the overall IC package 100. By contrast, in this example, the package mounting surface 106 is an outer or exterior surface of the IC package 100.

In some examples, an underfill material 124 is disposed between the dies 108, 110 and the package substrate 112 around and/or between the first level interconnects 116. In the illustrated example, only the first die 108 is associated with the underfill material 124. However, in other examples, both dies 108, 110 are associated with the underfill material 124. In other examples, the underfill material 124 is omitted. In some examples, the mold compound used for the package lid 114 is used as an underfill material that surrounds the first level interconnects 116.

In some examples, the IC package 100 includes additional passive components, such as surface-mount resistors, capacitors, and/or inductors disposed on the package mounting surface 106 of the package substrate 112 and/or the die mounting surface 120 of the package substrate 112.

In some examples, the first and second dies 108, 110 are communicatively coupled to one another through the package substrate 112. Specifically, in some examples, the package substrate 112 includes one or more metal layers that define traces and/or routing between the dies 108, 110. Additionally or alternatively, in some examples, the package substrate 112 includes a silicon-based interconnect bridge (e.g., an embedded interconnect bridge (EMIB)) embedded therein. In some such examples, the interconnect bridge underlies and spans between the first and second dies 108, 110 to provide electrical connections therebetween. Such interconnect bridges can provide traces at finer line spacing (e.g., pitch) than is possible in the metal layers of standard package substrates for increased connection densities. However, as the number of disaggregated dies in a package increases and the associated amount of data to be transferred between these separate dies increases, electrically conductive interconnects between dies are reaching their limits in terms of bandwidth and power consumption.

In the illustrated example, the limitations of electrical interconnects to facilitate communications between disaggregated dies (e.g., the first and second dies 108, 110) is resolved by optical links or waveguides 126 (referred to herein as bridge waveguides because they bridge a space or gap between two different dies 108, 110). Thus, in this example, the semiconductor dies 108, 110 are photonic integrated circuits (PICs) that include at least one photoactive component to generate, transmit, and/or receive light. In some examples, the bridge waveguides 126 completely replace the need for electrical connections between the dies 108, 110 to be provided through the package substrate. That is, in some examples, there is no interconnect bridge embedded in the package substrate 112 and no electrical routing that directly connects the dies 108, 110. Additionally or alternatively, in some examples, the disclosed example waveguides 126 can be used in combination with electrical interconnects between the dies 108, 110 through the package substrate 112. Further, in some examples, when there is more than two dies, a first pair of the dies may be communicatively coupled exclusively by way of electrical interconnects and a second pair of the dies may be communicatively coupled exclusively by way of optical interconnects.

In the past, optical connections between PICs and/or other photonic components have relied on optical fibers to carry the light between components. However, such optical systems rely on very accurate mechanical positioning of the fibers for reliable optical communication. Moreover, optical fibers cannot be scaled to a large number of parallel optical links positioned at a relatively fine pitch needed for communications between modern disaggregated dies. Examples disclosed herein overcome the concerns of optical fibers and their mechanical positioning by fabricating bridge waveguides 128 lithographically in place between the dies 108, 110. More particularly, in this example, the bridge waveguide 126 is lithographically fabricated on a gap filler 130 (e.g., filler material) deposited in the space or gap 128 or space between the dies 108. Lithographically patterning, etching, and/or depositing materials to create the bridge waveguides 124 has much higher accuracy than the known mechanical alignment techniques employed to connect optical fibers. Furthermore, such fabrication processes can be easily scaled to any suitable number of parallel waveguides without adding additional operations. That is, lithographically pattern, etching, and/or depositing materials to fabricate one waveguide involves the same number of operations as it does to fabricate ten waveguides, one hundred waveguides, or more.

In some examples, the gap filler 130 includes a first polymer with a first refractive index that is relatively low (e.g., less than 1.5 and as low as 1.3 or lower), and the bridge waveguide 126 includes a different, second polymer with a second refractive index that is relatively high (e.g., at least 1.5 and as high as 1.7 or higher). In some examples, the particular refractive index for each of the materials is less important than that the second refractive index (associated with the bridge waveguide 126) is higher than the first refractive index (associated with the gap filler 130). Further, in some examples, greater differences between the first and second refractive indices provides for greater refractive index contrast, which improves the efficiency of the bridge waveguides 126. Example materials for the first low-n polymer include fluorinated polymers such as CYTOP^{®}. Example materials for the second high-n polymer include epoxy-based resins or photoresists such as SU-8.

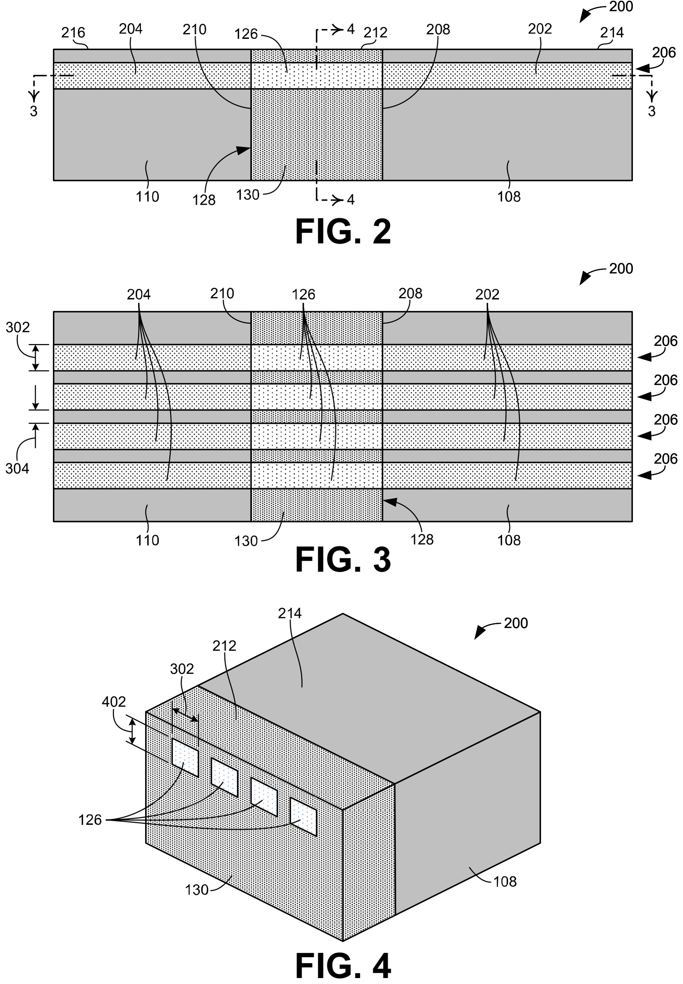

In some examples, the gap filler 130 fill a significant portion of the gap 128 (e.g., at least 25%, at least 50%, at least 75%, an entirety of the gap except for the portion associated with the bridge waveguide 126). In the illustrated example, the gap filler 130 surrounds all sides of the bridge waveguide 126 (e.g., the gap filler 130 is above and below the waveguide 126). In other examples, the gap filler 130 does not cover (e.g., leaves exposed) at least one side of the bridge waveguide 126. In some examples, the exposed side(s) of the bridge waveguide 126 are exposed to air (which has a refractive index of approximately 1) to increase (e.g., maximize the refractive index contrast). In some examples, multiple sides and/or all sides of the bridge waveguide 126 are spaced apart from the gap filler 130. Different examples configurations of the bridge waveguides 128 and the gap filler 130 are detailed further below in connection with FIGS. 2-10.

FIG. 2 is an enlarged cross-sectional side view of an example assembly 200 representing a first example implementation of the optical coupling of the first and second dies 108, 110 of FIG. 1. FIG. 3 is a cross-sectional top view of the example assembly 200 of FIG. 2 taken along the line 3-3 shown in FIG. 2. FIG. 4 is a top perspective cutaway view of the example assembly 200 of FIG. 2 taken along the line 4-4 shown in FIG. 2. As shown in the illustrated example, the first semiconductor die 108 includes a first array of waveguides 202 that are coupled to a photoactive component (not shown) within the first die 108. Similarly, in this example, the second semiconductor die 110 includes a second array of waveguides 204 that are coupled to a photoactive component (not shown) within the second die 110. For purposes of explanation, the waveguides 202, 204 within the dies 108, 110 are referred to as internal waveguides to distinguish them from the bridge waveguides 126 that are external to and between the dies 108, 110. In this example, the internal waveguides 202, 204 end at exterior surfaces (e.g., sidewalls 208, 210) of the respective dies 108, 110 to enable optical coupling to the bridge waveguide 126. More particularly, in this example, corresponding ones of the internal waveguides 202, 204 in each of the dies 108, 110 are optically coupled by a corresponding array of bridge waveguides 126 to define a plurality (e.g., an array) of optical communication channels 206.

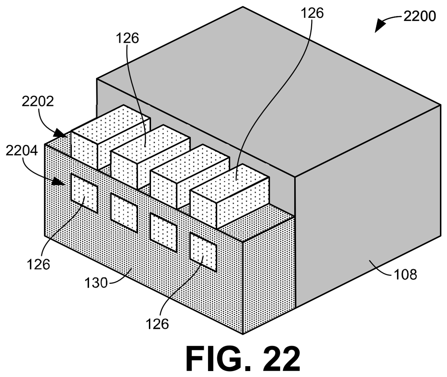

As shown in the illustrated example of FIG. 3, four separate communication channels 206 are shown. However, in some examples, any suitable number of channels 206 can be provided to communicatively couple the two dies 108, 110. As mentioned above and discussed further below, the number of channels 206 does not significantly affect the fabrication process because all bridge waveguides (regardless of the number) can be fabricated simultaneously in the same process(es). Further, in this example, all of the communication channels 206 are in a same plane (e.g., within a single waveguide layer) that extends horizontally (e.g., substantially parallel to the package substrate 112 on which the dies 108, 110 are mounted as shown in FIG. 1). However, in some examples, different communication channels 206 can be implemented in different waveguide layers that are stacked vertically (as discussed further below in connection with FIG. 22).

In this example, the waveguides 126, 202, 204 along each communication channel 206 have a width 302 that is between approximately 500 nanometers (nm) and 1.5 micrometers (µm). However, in other examples, the width 302 can be less than 500 nm or greater than 1.5 µm. In some examples, the width 302 is comparable to the size of the internal waveguides 202, 204 within the dies 108, 110. In other examples, the width 302 can be significantly larger (e.g., at least two times the size, at least five times the size, upwards of ten times the size) than the width of the internal waveguides 202, 204 to facilitate optical coupling and alignment. In some such examples, mode expansion techniques (e.g., adiabatic tapers, mode converters, etc.) can be employed to enlarge the ends of the internal waveguides 202, 204 that are proximate the bridge waveguides 126.

As shown in the illustrated example of FIG. 3, the width 302 is greater than a distance 304 between adjacent ones of the waveguides 126, 202, 204. However, in other examples, the distance 304 is equal to or greater than the width 302 (e.g., at least 1.5 times the width 302, at least 2 times the width 302) to reduce (e.g., avoid) crosstalk between the different channels. Further, in this example, the width 302 of the waveguides 126, 202, 204 is approximately equal to a height or thickness 402 (FIG. 4) of the waveguides 126, 202, 204. In other examples, the thickness 402 may be greater or less than the width 302 (e.g., between 0.5 times the width 302 and 1.5 times the width 302).

In this example, the bridge waveguides 126 extend a full distance across the gap between the dies 108, 110 so as to be in contact with (e.g., abutting) facing sidewalls 208, 210 of the respective dies 108, 110. Similarly, in some examples, the gap filler 130 extends the full distance across the gap between the dies 108, 110 so as to be in contact with (e.g., abutting) the facing sidewalls 208, 210. Further, in this example, the gap filler 130 is in direct contact (e.g., interfaces with) the bridge waveguides 126. More particularly, as shown in the illustrated example of FIG. 4, the gap filler 130 completely surrounds all sides of the bridge waveguides 128. In the illustrated example, the gap filler 130 has an upper surface 212 that extends up to (e.g., is flush with) upper surfaces 214, 216 of the semiconductor dies 108, 110. In other examples, the upper surface 212 of the gap filler 130 is recessed relative to the upper surfaces 214, 216 of the dies 108, 110 while still extending over and above the bridge waveguides 126.

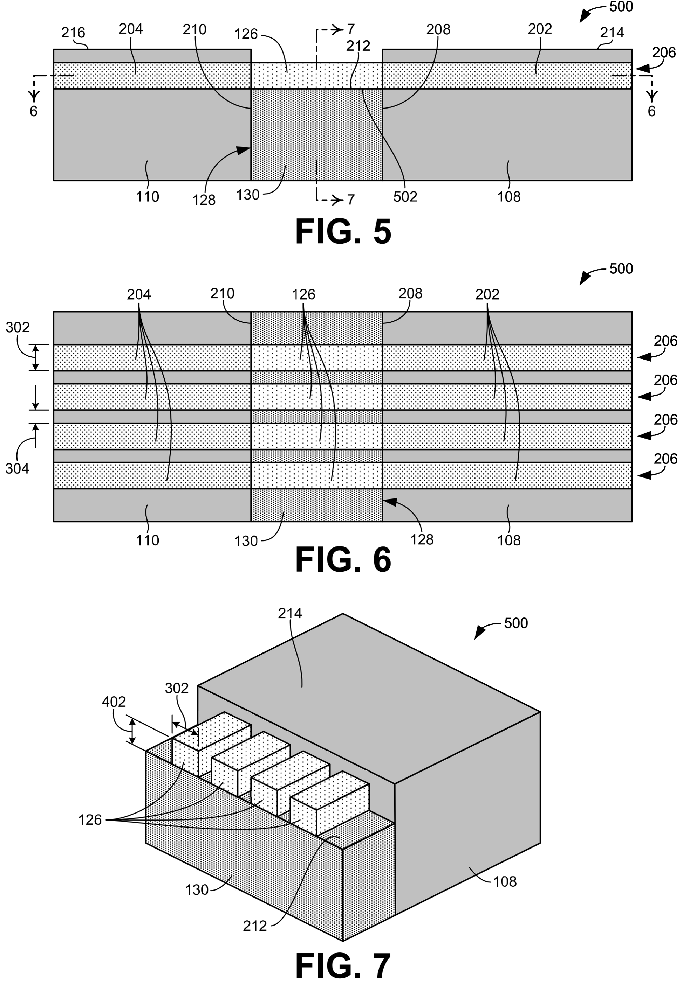

FIG. 5 is an enlarged cross-sectional side view of another example assembly 500 representing a second example implementation of the optical coupling of the first and second dies 108, 110 of FIG. 1. FIG. 6 is a cross-sectional top view of the example assembly 500 of FIG. 5 taken along the line 6-6 shown in FIG. 5. FIG. 7 is a top perspective cutaway of the example assembly 500 of FIG. 5 taken along the line 7-7 shown in FIG. 5. The example assembly 500 of FIGS. 5-7 is substantially the same as the example assembly 200 of FIGS. 2-4 except as noted below or otherwise made clear from the context. Accordingly, the same reference numbers are used in FIGS. 5-7 for the same or similar features as used in FIG. 2-4 and the description of such features provided above applies equally to the corresponding features shown in FIGS. 5-7.

The example of FIGS. 5-7 differs from the example of FIGS. 2-4 in that the upper surface 212 of the gap filler 130 corresponds to (e.g., is aligned with) bottom surfaces 502 of the bridge waveguides 126. That is, the bridge waveguides 128 correspond to ridges protruding from and extending along the upper surface 212 of the gap filler 130. Stated differently, in this example, the gap filler 130 substantially fills the portion of the gap 128 between the first and second dies 108, 110 that is below the bridge waveguides 126 (e.g., between the package substrate 112 shown in FIG. 1 and the bridge waveguides 126). In this context, "substantially fills" means at least 80%. Thus, as shown in the illustrated example, three of the four sides of the bridge waveguides 126 are exposed to surrounding air. Exposure of the bridge waveguides 126 to air can improve optical performance because air has a refractive index that is lower than the materials that would be used for the gap filler 130, thereby providing a greater refractive index contrast.

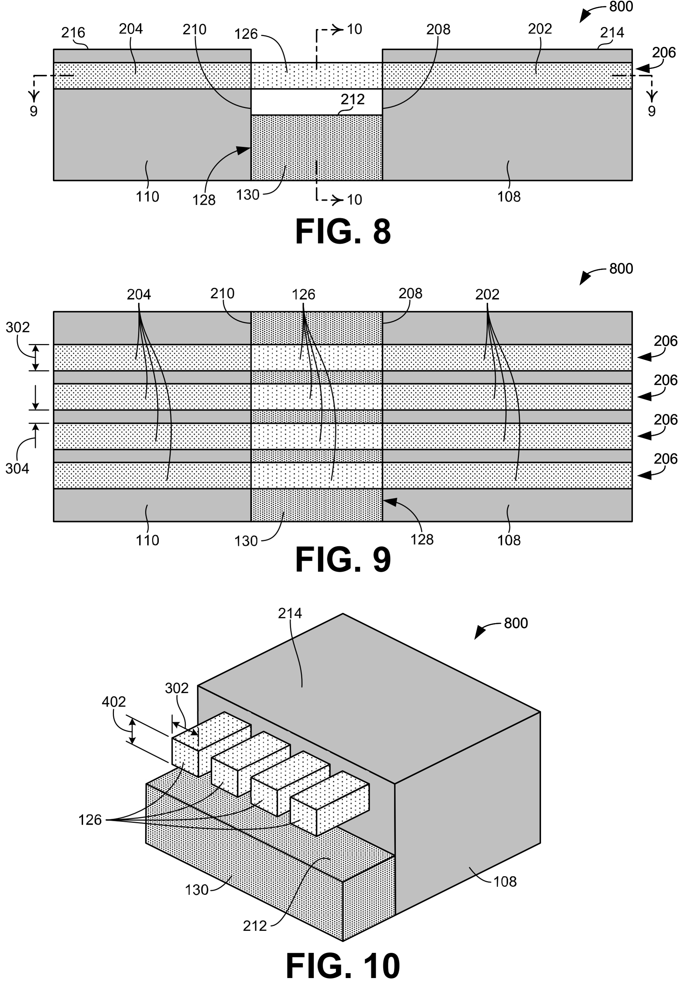

FIG. 8 is an enlarged cross-sectional side view of another example assembly 800 representing a third example implementation of the optical coupling of the first and second dies 108, 110 of FIG. 1. FIG. 9 is a cross-sectional top view of the example assembly 800 of FIG. 8 taken along the line 9-9 shown in FIG. 8. FIG. 10 is a top perspective cutaway view of the example assembly 800 of FIG. 8 taken along the line 10-10 shown in FIG. 8. The example assembly 800 of FIGS. 8-10 is substantially the same as the example assembly 200 of FIGS. 2-4 except as noted below or otherwise made clear from the context. Accordingly, the same reference numbers are used in FIGS. 8-7 for the same or similar features as used in FIG. 2-4 and the description of such features provided above applies equally to the corresponding features shown in FIGS. 8-10.

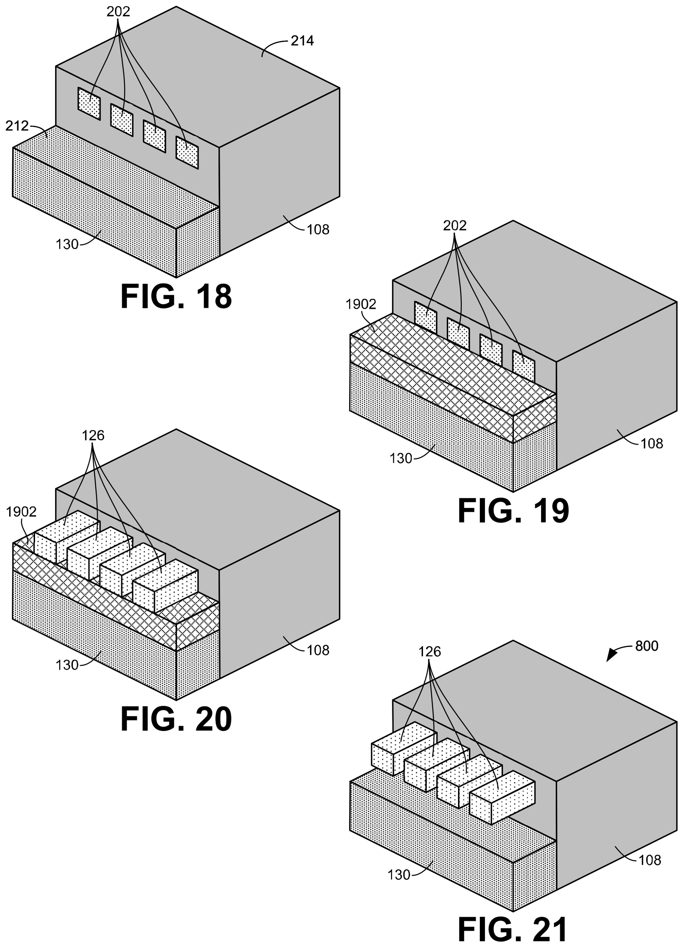

The example of FIGS. 8-10 differs from the example of FIGS. 2-4 in that the upper surface 212 of the gap filler 130 is spaced apart from and below the bridge waveguides 126. That is, the bridge waveguides 128 correspond to freestanding bridges that span the distance or gap between the dies 108, 110. Thus, as shown in the illustrated example, all four sides (e.g., an entire exterior of the elongate length) of the bridge waveguides 126 are exposed to surrounding air for greater refractive index contrast than possible in the other examples shown in FIGS. 2-4 and FIGS. 5-7. In other words, a full perimeter of a cross-section of the bridge waveguides 126 taken in a direction transverse to the elongate length of the bridge waveguides 126 is uncovered and exposed to surrounding air. In some such examples, the gap filler 130 is omitted entirely. However, in some examples, the gap filler 130 is retained as it is used to fabricate the freestanding bridge waveguides 126 as discussed further below in connection with FIGS. 18-21.

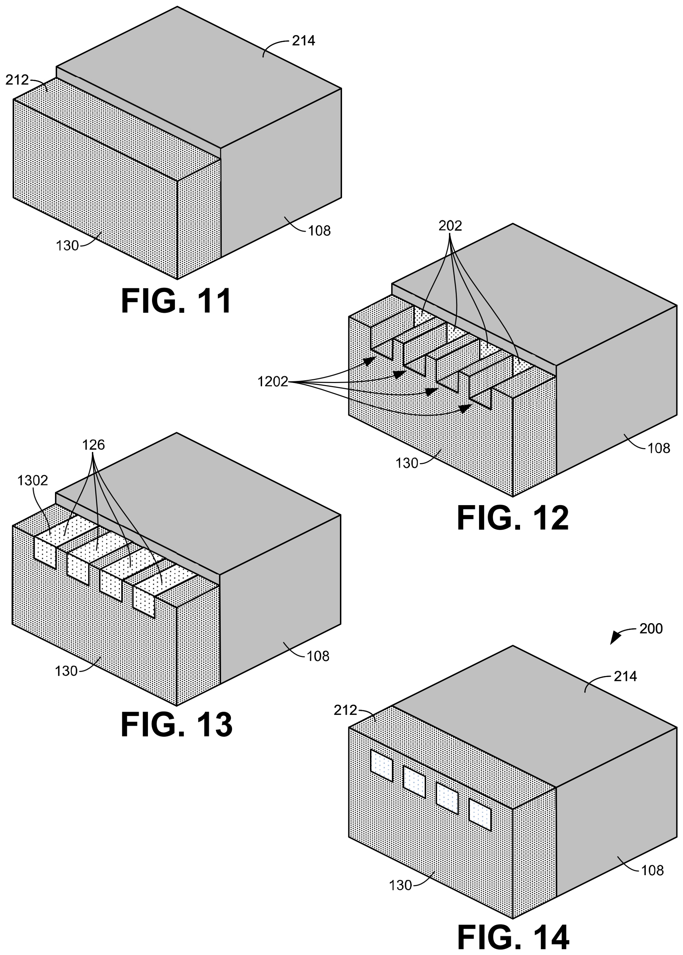

FIGS. 11-14 illustrate different stages in an example process to manufacture the example assembly 200 of FIGS. 2-4. FIGS. 11-14 correspond to the same top perspective cutaway view as shown in FIG. 4. FIG. 11 represents the stage of fabrication following the deposition of the gap filler 130 (e.g., a low-n material) in the gap or space between the first and second dies 108, 110. Thus, the stage of fabrication represented in FIG. 11 is after the first and second dies 108, 110 have already been mounted on to the package substrate 112 as shown in FIG. 1. In some examples, the amount of the gap filler 130 deposited at the stage represented in FIG. 11 results in the upper surface 212 of the gap filler 130 being lower than the upper surface 214 of the first die 108. That is, in some examples, the gap filler 130 does not completely fill the gap or space between the dies 108, 110. However, in this example, a sufficient amount of gap filler 130 is added so that the upper surface 212 of the gap filler 130 is at least up to where the top surface of the bridge waveguides 126. In other words, the gap filler 130 is added up to a height that at least covers the ends of the internal waveguides 202, 204 within the adjacent semiconductor dies 108, 110. In some examples, the gap filler 130 can be added to completely fill the space between the dies 108, 110 such that the upper surface 212 of the gap filler 130 is flush with the upper surface 214 of the first die 108. In some examples, the space between the dies 108, 110 can be overfilled such that the gap filler 130 extends above and/or over the upper surfaces 214, 216 of the dies 108, 110. In some such examples, the excess gap filler 130 is removed later in the fabrication process.

FIG. 12 represents the stage of fabrication following an etching process to provide trenches 1202 within the gap filler 130. The trenches 1202 define the location where the bridge waveguides 126 are to be located. In some examples, the size, location, and etching of the trenches 1202 is achieved using any suitable photolithography processes. For instance, in some examples, a mask is lithographically patterned over top of the gap filler 130 to define the size and location of the trenches 1202. In such examples, after etching away the gap filler 130 to define the trenches 1202, the mask can be removed. As shown in FIG. 12, etching away the gap filler 130 to define the trenches 1202 reveals or exposes the ends of the internal waveguides 202 in the first semiconductor die 108. The trenches 1202 similarly uncover the corresponding ends of the internal waveguides 204 in the second semiconductor die 110. In the illustrated example, the ends of the trenches 1202 are substantially the same size as the ends of the internal waveguides 202, 204. However, in any of the examples disclosed herein, the ends of internal waveguides 202, 204 can be constructed with optical modes of increased size relative to the main length of the waveguides 202, 204. The larger ends of the internal waveguides 202, 204 help to ensure there is suitable optical coupling even in the event of some misalignment between the different waveguides 126, 202, 204 based on the placement of the semiconductor dies 108, 110 relative to the lithography processes involved in patterning and creating the bridge waveguides 126 extending therebetween. In some examples, the size of the ends of the internal waveguides is expanded via adiabatic tapering and/or with one more mode conversion structures disposed in the semiconductor dies 108, 110.

FIG. 13 represents the stage of fabrication following the deposition of a waveguide material 1302 (e.g., a high-n material) for the bridge waveguides 126. As shown in the illustrated example, the waveguide material 1302 is deposited within the trenches 1202 previously provided in the gap filler 130. As a result, the shape and location of the trenches 1202 defines the shape and location of the bridge waveguides 126 in the gap or space between the first and second dies 108, 110. In some examples, the mask patterned over the gap filler 130 to produce the trenches 1202 is retained until after depositing the waveguide material 1302 to produce the bridge waveguides 126. As indicated above, inasmuch as the bridge waveguides 126 are defined by etching trenches 1202 in a single series of lithography processes and the bridge waveguides 126 are created in a single deposition process, any suitable number of bridge waveguides 126 can be fabricated at the same time. As a result, this approach can be scaled to much larger numbers of optical connections than is possible when mechanically aligning individual optical fibers.

FIG. 14 represents the stage of fabrication following the deposition of additional amounts of the gap filler 130 to cover the bridge waveguides 126. In this example, the gap filler 130 is added to completely fill the space between the dies such that the upper surface 212 of the gap filler reaches up to (e.g., is flush with) the upper surfaces 214, 216 of the semiconductor dies 108, 110. In some examples, excess gap filler 130 is deposited above and beyond the upper surfaces 214, 216 of the dies 108, 110 and subsequently removed (e.g., via a grinding and/or planarization process). The stage represented in FIG. 14 represents a completion of the process. Thus, as can be seen, FIG. 14 is the same as the completed example assembly 200 shown in FIGS. 2-4. In some examples, the material used for the gap filler 130 above the bridge waveguides 126 is different than the material used below the waveguides 126. In some examples, the gap filler 130 above the waveguides 126 is omitted such that the final construction is what is shown in FIG. 13 with one side of the bridge waveguides 126 exposed to air.

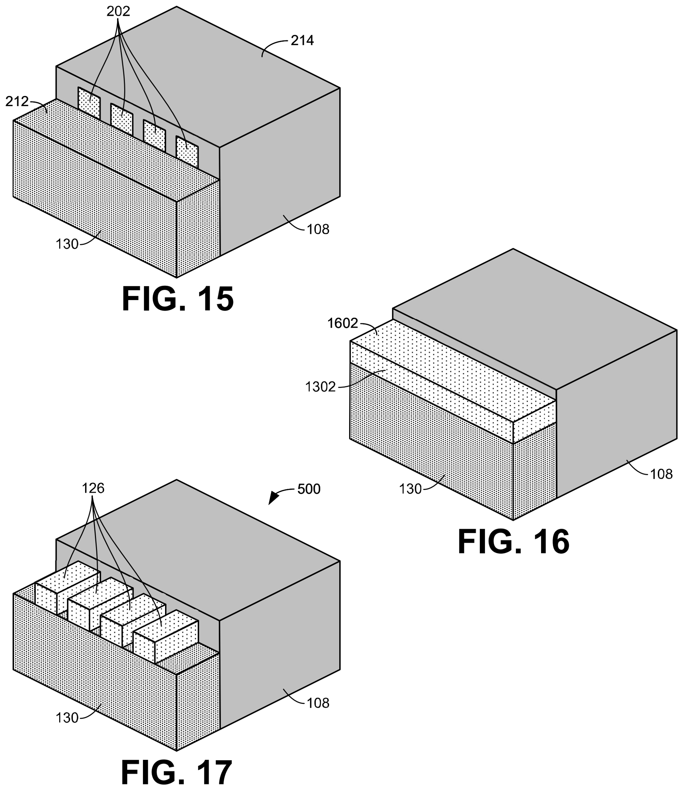

FIGS. 15-17 illustrate different stages in an example process to manufacture the example assembly 500 of FIGS. 5-7. FIGS. 15-17 correspond to the same top perspective cutaway view as shown in FIG. 7. FIG. 15 represents the stage of fabrication following the deposition of the gap filler 130 in the gap or space between the first and second dies 108, 110. This stage of fabrication is similar to the stage of fabrication represented in FIG. 11 and, thus, the description above applies similarly here. However, the stage of fabrication represented in FIG. 15 differs from the example shown in FIG. 11 in the height of the gap filler 130. Whereas the gap filler 130 in the example of FIG. 11 was added up to at least the top of the where the bridge waveguides 126 are to be added, in the illustrated example of FIG. 15, the upper surface 212 of the gap filler 130 is controlled to the bottom of where the bridge waveguides 126 are to be added. That is, as shown in the illustrated example, the upper surface 212 of the gap filler 130 is aligned with the bottom of the ends of the internal waveguides 202 within the first semiconductor die 108.

FIG. 16 represents the stage of fabrication following the deposition of the waveguide material 1302 for the bridge waveguides 126. In this example, the waveguide material 1302 is added as one continuous layer across the upper surface of the gap filler 130. In some examples, the layer of waveguide material 1302 added at this stage in the process is defined with a thickness corresponding to the thickness 402 of the bridge waveguides 126. In this manner, the upper surface 1602 of the deposited waveguide material 1302 defines the top of the bridge waveguides 126.

FIG. 17 represents the stage of fabrication following an etching process to remove excess portions of the layer of waveguide material 1302 added for the bridge waveguides 126 so that only the bridge waveguides 126 remain. This process can be similar to the process described above in connection with FIG. 12 except that, in the example of FIG. 17, the trenches correspond to the space between the bridge waveguides 126. The stage represented in FIG. 17 represents a completion of the process. Thus, as can be seen, FIG. 17 is the same as the completed example assembly 500 as shown in FIGS. 5-7. The final assembly 500 can be achieved in other ways. For instance, in some examples, the process up through what is represented in FIG. 13 can be followed as described above. Then, rather than adding additional gap filler 130, the gap filler 130 between the bridge waveguides 126 can be removed (e.g., via etching) to arrive at the same end result shown in FIG. 17.

FIGS. 18-21 illustrate different stages in an example process to manufacture the example assembly 800 of FIGS. 8-10. FIGS. 18-21 correspond to the same top perspective cutaway view as shown in FIG. 10. FIG. 18 represents the stage of fabrication following the deposition of the gap filler 130 in the gap or space between the first and second dies 108, 110. This stage of fabrication is similar to the stages of fabrication represented in FIG. 11 and, thus, the description above applies similarly here. However, the stage of fabrication represented in FIG. 18 differs from the example shown in FIG. 11 in the height of the gap filler 130. In the illustrated example of FIG. 18, the upper surface 212 of the gap filler 130 remains spaced apart from and below the bottom of where the bridge waveguides 126 are to be added. Thus, as shown in the illustrated example, the upper surface 212 of the gap filler 130 is separated from and below the bottom of the ends of the internal waveguides 202 within the first semiconductor die 108.

FIG. 19 represents the stage of fabrication following the deposition of a sacrificial material 1902 over the gap filler 130 to fille up the space up to the bottom of where the bridge waveguides 126 are to be added. That is, the sacrificial material 1902 is added up to the height of the gap filler 130 shown in the illustrated example of FIG. 15.

FIG. 20 represents the addition of bridge waveguides 126 onto the sacrificial material 1902. In some examples, the bridge waveguides 126 are added according to any of the example fabrication processes discussed above in connection with FIGS. 16 and 17.

FIG. 21 represents the stage of fabrication following the removal (e.g., via an etching process) of the sacrificial material 1902 from underneath the bridge waveguides 126. The stage represented in FIG. 21 represents a completion of the process. Thus, as can be seen, FIG. 21 is the same as the completed example assembly 800 as shown in FIGS. 8-10. In some examples, the gap filler 130 is omitted and the sacrificial material 1902 is used to fill the gap or space between the dies 108, 110 up to the height represented in FIG. 19. In such examples, when the sacrificial material 1902 is removed, the only material within the gap between the dies 108, 110 is the freestanding bridge waveguides 126 with all four sides exposed to air.

FIG. 22 illustrates an example assembly 2200 representing a fourth example implementation of the optical coupling of the first and second dies 108, 110 of FIG. 1. In this example, the assembly 2200 includes a first array 2202 of bridge waveguides 126 and a second array 2204 of bridge waveguides 126 in two different planes. That is, in this example, the bridge waveguides 126 in the second array 2204 are closer to an underlying package substrate 112 (shown in FIG. 1) than the bridge waveguides 126 in the first array 2202. In this example, the second array 2204 of bridge waveguides 126 are completely surrounded by the gap filler 130 (similar to what is shown in FIGS. 2-4) while the first array 2202 are resting on (e.g., supported by) the gap filler 130 but otherwise uncovered and exposed to the surrounding are (similar to what is shown in FIGS. 5-7. However, other arrangements are possible. For example, both arrays 2202, 2204 could be surrounded by the gap filler 130. In other examples, both of the arrays 2202, 2204 could be at least partially uncovered and exposed to the surrounding air. Additionally or alternatively, in some examples, one or both of the arrays 2202, 2204 could be completely spaced apart from the gap filler 130 (similar to what is shown in FIGS. 8-10. In other words, the vertical stacking of bridge waveguides 126 (in association with a vertical stacking of internal waveguides 202, 204 can be implemented in connection with any of the example assemblies 200, 500, 800 disclosed above.

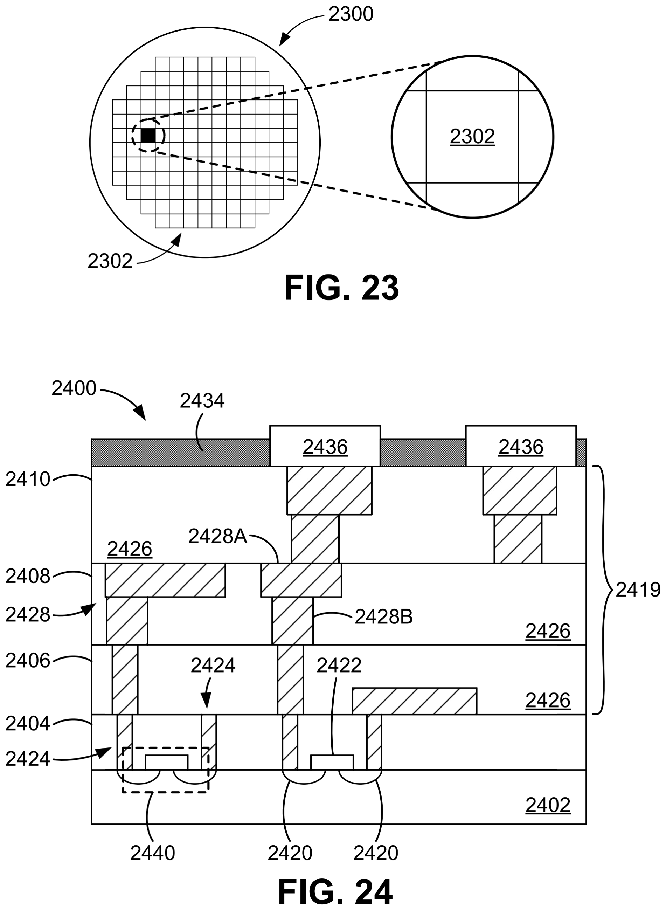

The example IC package 100 including one or more of any of the example assemblies 200, 500, 800, 2200 disclosed herein may be included in any suitable electronic component. FIGS. 23-26 illustrate various examples of apparatus that may include or be included in the IC package 100 disclosed herein.

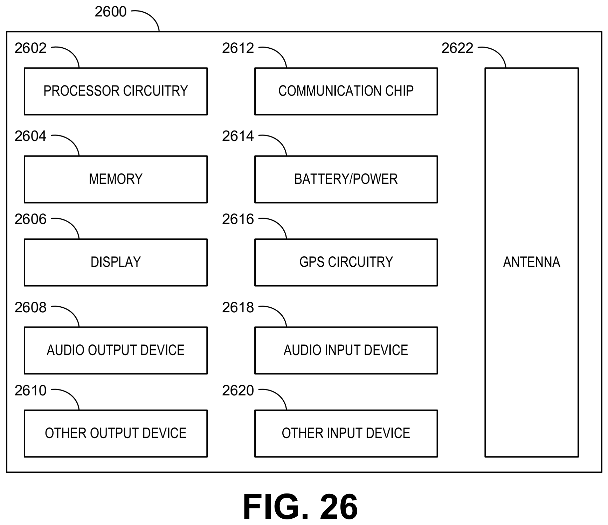

FIG. 23 is a top view of a wafer 2300 and dies 2302 that may be included in the IC package 100 of FIG. 1 (e.g., such as any suitable ones of the dies 108, 110). The wafer 2300 includes semiconductor material and one or more dies 2302 having circuitry. Each of the dies 2302 may be a repeating unit of a semiconductor product. After the fabrication of the semiconductor product is complete, the wafer 2300 may undergo a singulation process in which the dies 2302 are separated from one another to provide discrete "chips." The die 2302 includes one or more transistors (e.g., some of the transistors 2440 of FIG. 24, discussed below), supporting circuitry to route electrical signals to the transistors, passive components (e.g., traces, resistors, capacitors, inductors, and/or other circuitry), and/or any other components. In some examples, the die 2302 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 2302. For example, a memory array of multiple memory circuits may be formed on a same die 2302 as programmable circuitry (e.g., the processor circuitry 2602 of FIG. 26) and/or other logic circuitry. Such memory may store information for use by the programmable circuitry. The example IC package 100 disclosed herein may be manufactured using a die-to-wafer assembly technique in which some dies are attached to a wafer 2300 that includes others of the dies, and the wafer 2300 is subsequently singulated.

FIG. 24 is a cross-sectional side view of an IC device 2400 that may be included in the example IC package 100 (e.g., in any one of the dies 108, 110). One or more of the IC devices 2400 may be included in one or more dies 2302 (FIG. 23). The IC device 2400 may be formed on a die substrate 2402 (e.g., the wafer 2300 of FIG. 23) and may be included in a die (e.g., the die 2302 of FIG. 23). The die substrate 2402 may be a semiconductor substrate including semiconductor materials including, for example, n-type or p-type materials systems (or a combination of both). The die substrate 2402 may include, for example, a crystalline substrate formed using a bulk silicon or a silicon-on-insulator (SOI) substructure. In some examples, the die substrate 2402 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 2402. Although a few examples of materials from which the die substrate 2402 may be formed are described here, any material that may serve as a foundation for an IC device 2400 may be used. The die substrate 2402 may be part of a singulated die (e.g., the dies 2302 of FIG. 23) or a wafer (e.g., the wafer 2300 of FIG. 23).

The IC device 2400 may include one or more device layers 2404 disposed on and/or above the die substrate 2402. The device layer 2404 may include features of one or more transistors 2440 (e.g., metal oxide semiconductor field-effect transistors (MOSFETs)) formed on the die substrate 2402. The device layer 2404 may include, for example, one or more source and/or drain (S/D) regions 2420, a gate 2422 to control current flow between the S/D regions 2420, and one or more S/D contacts 2424 to route electrical signals to/from the S/D regions 2420. The transistors 2440 may include additional features not depicted for the sake of clarity, such as device isolation regions, gate contacts, and the like. The transistors 2440 are not limited to the type and configuration depicted in FIG. 24 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 2440 may include a gate 2422 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 2440 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 2440 along the source-channel-drain direction, the gate electrode may include a U-shaped structure that includes a bottom portion substantially parallel to the surface of the die substrate 2402 and two sidewall portions that are substantially perpendicular to the top surface of the die substrate 2402. In other examples, at least one of the metal layers that form the gate electrode may be a planar layer that is substantially parallel to the top surface of the die substrate 2402 and does not include sidewall portions substantially perpendicular to the top surface of the die substrate 2402. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 2420 may be formed within the die substrate 2402 adjacent to the gate 2422 of corresponding transistor(s) 2440. The S/D regions 2420 may be formed using an implantation/diffusion process or an etching/deposition process, for example. In the former process, dopants such as boron, aluminum, antimony, phosphorous, or arsenic may be ion-implanted into the die substrate 2402 to form the S/D regions 2420. An annealing process that activates the dopants and causes them to diffuse farther into the die substrate 2402 may follow the ion-implantation process. In the latter process, the die substrate 2402 may first be etched to form recesses at the locations of the S/D regions 2420. An epitaxial deposition process may then be carried out to fill the recesses with material that is used to fabricate the S/D regions 2420. In some implementations, the S/D regions 2420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 2420 may be formed using one or more alternate semiconductor materials such as germanium or a group III-V material or alloy. In further examples, one or more layers of metal and/or metal alloys may be used to form the S/D regions 2420.

Electrical signals, such as power and/or input/output (I/O) signals, may be routed to and/or from the devices (e.g., transistors 2440) of the device layer 2404 through one or more interconnect layers disposed on the device layer 2404 (illustrated in FIG. 24 as interconnect layers 2406-2410). For example, electrically conductive features of the device layer 2404 (e.g., the gate 2422 and the S/D contacts 2424) may be electrically coupled with the interconnect structures 2428 of the interconnect layers 2406-2410. The one or more interconnect layers 2406-2410 may form a metallization stack (also referred to as an "ILD stack") 2419 of the IC device 2400.

The interconnect structures 2428 may be arranged within the interconnect layers 2406-2410 to route electrical signals according to a wide variety of designs (in particular, the arrangement is not limited to the particular configuration of interconnect structures 2428 depicted in FIG. 24). Although a particular number of interconnect layers 2406-2410 is depicted in FIG. 24, examples of the present disclosure include IC devices having more or fewer interconnect layers than depicted.

In some examples, the interconnect structures 2428 may include lines 2428a and/or vias 2428b filled with an electrically conductive material such as a metal. The lines 2428a may be arranged to route electrical signals in a direction of a plane that is substantially parallel with a surface of the die substrate 2402 upon which the device layer 2404 is formed. For example, the lines 2428a may route electrical signals in a direction in and/or out of the page from the perspective of FIG. 24. The vias 2428b may be arranged to route electrical signals in a direction of a plane that is substantially perpendicular to the surface of the die substrate 2402 upon which the device layer 2404 is formed. In some examples, the vias 2428b may electrically couple lines 2428a of different interconnect layers 2406-2410 together.

The interconnect layers 2406-2410 may include a dielectric material 2426 disposed between the interconnect structures 2428, as shown in FIG. 24. In some examples, the dielectric material 2426 disposed between the interconnect structures 2428 in different ones of the interconnect layers 2406-2410 may have different compositions; in other examples, the composition of the dielectric material 2426 between different interconnect layers 2406-2410 may be the same.

A first interconnect layer 2406 (referred to as Metal 1 or "M1") may be formed directly on the device layer 2404. In some examples, the first interconnect layer 2406 may include lines 2428a and/or vias 2428b, as shown. The lines 2428a of the first interconnect layer 2406 may be coupled with contacts (e.g., the S/D contacts 2424) of the device layer 2404.

A second interconnect layer 2408 (referred to as Metal 2 or "M2") may be formed directly on the first interconnect layer 2406. In some examples, the second interconnect layer 2408 may include vias 2428b to couple the lines 2428a of the second interconnect layer 2408 with the lines 2428a of the first interconnect layer 2406. Although the lines 2428a and the vias 2428b are structurally delineated with a line within each interconnect layer (e.g., within the second interconnect layer 2408) for the sake of clarity, the lines 2428a and the vias 2428b may be structurally and/or materially contiguous (e.g., simultaneously filled during a dual-damascene process) in some examples.

A third interconnect layer 2410 (referred to as Metal 3 or "M3") (and additional interconnect layers, as desired) may be formed in succession on the second interconnect layer 2408 according to similar techniques and/or configurations described in connection with the second interconnect layer 2408 or the first interconnect layer 2406. In some examples, the interconnect layers that are "higher up" in the metallization stack 2419 in the IC device 2400 (i.e., further away from the device layer 2404) may be thicker.

The IC device 2400 may include a solder resist material 2434 (e.g., polyimide or similar material) and one or more conductive contacts 2436 formed on the interconnect layers 2406-2410. In FIG. 24, the conductive contacts 2436 are illustrated as taking the form of bond pads. The conductive contacts 2436 may be electrically coupled with the interconnect structures 2428 and configured to route the electrical signals of the transistor(s) 2440 to other external devices. For example, solder bonds may be formed on the one or more conductive contacts 2436 to mechanically and/or electrically couple a chip including the IC device 2400 with another component (e.g., a circuit board). The IC device 2400 may include additional or alternate structures to route the electrical signals from the interconnect layers 2406-2410; for example, the conductive contacts 2436 may include other analogous features (e.g., posts) that route the electrical signals to external components.

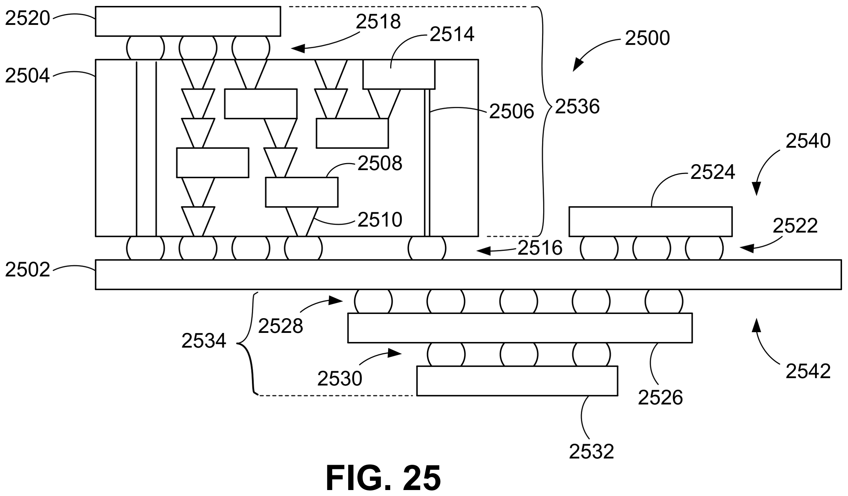

FIG. 25 is a cross-sectional side view of an IC device assembly 2500 that may include the IC package 100 disclosed herein. In some examples, the IC device assembly corresponds to the IC package 100. The IC device assembly 2500 includes a number of components disposed on a circuit board 2502 (which may be, for example, a motherboard). The IC device assembly 2500 includes components disposed on a first face 2540 of the circuit board 2502 and an opposing second face 2542 of the circuit board 2502; generally, components may be disposed on one or both faces 2540 and 2542. Any of the IC packages discussed below with reference to the IC device assembly 2500 may take the form of the example IC package 100 of FIG. 1.

In some examples, the circuit board 2502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2502. In other examples, the circuit board 2502 may be a non-PCB substrate.

The IC device assembly 2500 illustrated in FIG. 25 includes a package-on-interposer structure 2536 coupled to the first face 2540 of the circuit board 2502 by coupling components 2516. The coupling components 2516 may electrically and mechanically couple the package-on-interposer structure 2536 to the circuit board 2502, and may include solder balls (as shown in FIG. 25), male and female portions of a socket, an adhesive, an underfill material, and/or any other suitable electrical and/or mechanical coupling structure.

The package-on-interposer structure 2536 may include an IC package 2520 coupled to an interposer 2504 by coupling components 2518. The coupling components 2518 may take any suitable form for the application, such as the forms discussed above with reference to the coupling components 2516. Although a single IC package 2520 is shown in FIG. 25, multiple IC packages may be coupled to the interposer 2504; indeed, additional interposers may be coupled to the interposer 2504. The interposer 2504 may provide an intervening substrate used to bridge the circuit board 2502 and the IC package 2520. The IC package 2520 may be or include, for example, a die (the die 2302 of FIG. 23), an IC device (e.g., the IC device 2400 of FIG. 24), or any other suitable component. Generally, the interposer 2504 may spread a connection to a wider pitch or reroute a connection to a different connection. For example, the interposer 2504 may couple the IC package 2520 (e.g., a die) to a set of BGA conductive contacts of the coupling components 2516 for coupling to the circuit board 2502. In the example illustrated in FIG. 25, the IC package 2520 and the circuit board 2502 are attached to opposing sides of the interposer 2504; in other examples, the IC package 2520 and the circuit board 2502 may be attached to a same side of the interposer 2504. In some examples, three or more components may be interconnected by way of the interposer 2504.

In some examples, the interposer 2504 may be formed as a PCB, including multiple metal layers separated from one another by layers of dielectric material and interconnected by electrically conductive vias. In some examples, the interposer 2504 may be formed of an epoxy resin, a fiberglass-reinforced epoxy resin, an epoxy resin with inorganic fillers, a ceramic material, or a polymer material such as polyimide. In some examples, the interposer 2504 may be formed of alternate rigid or flexible materials that may include the same materials described above for use in a semiconductor substrate, such as silicon, germanium, and other group III-V and group IV materials. The interposer 2504 may include metal interconnects 2508 and vias 2510, including but not limited to through-silicon vias (TSVs) 2506. The interposer 2504 may further include embedded devices 2514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 2504. The package-on-interposer structure 2536 may take the form of any of the package-on-interposer structures known in the art.

The IC device assembly 2500 may include an IC package 2524 coupled to the first face 2540 of the circuit board 2502 by coupling components 2522. The coupling components 2522 may take the form of any of the examples discussed above with reference to the coupling components 2516, and the IC package 2524 may take the form of any of the examples discussed above with reference to the IC package 2520.

The IC device assembly 2500 illustrated in FIG. 25 includes a package-on-package structure 2534 coupled to the second face 2542 of the circuit board 2502 by coupling components 2528. The package-on-package structure 2534 may include a first IC package 2526 and a second IC package 2532 coupled together by coupling components 2530 such that the first IC package 2526 is disposed between the circuit board 2502 and the second IC package 2532. The coupling components 2528, 2530 may take the form of any of the examples of the coupling components 2516 discussed above, and the IC packages 2526, 2532 may take the form of any of the examples of the IC package 2520 discussed above. The package-on-package structure 2534 may be configured in accordance with any of the package-on-package structures known in the art.

FIG. 26 is a block diagram of an example electrical device 2600 that may include one or more of the example IC package 100. For example, any suitable ones of the components of the electrical device 2600 may include one or more of the device assemblies 2500, IC devices 2400, or dies 2302 disclosed herein, and may be arranged in the example IC package 100. A number of components are illustrated in FIG. 26 as included in the electrical device 2600, but any one or more of these components may be omitted or duplicated, as suitable for the application. In some examples, some or all of the components included in the electrical device 2600 may be attached to one or more motherboards. In some examples, some or all of these components are fabricated onto a single system-on-a-chip (SoC) die.

Additionally, in various examples, the electrical device 2600 may not include one or more of the components illustrated in FIG. 26, but the electrical device 2600 may include interface circuitry for coupling to the one or more components. For example, the electrical device 2600 may not include a display 2606, but may include display interface circuitry (e.g., a connector and driver circuitry) to which a display 2606 may be coupled. In another set of examples, the electrical device 2600 may not include an audio input device 2618 (e.g., microphone) or an audio output device 2608 (e.g., a speaker, a headset, earbuds, etc.), but may include audio input or output device interface circuitry (e.g., connectors and supporting circuitry) to which an audio input device 2618 or audio output device 2608 may be coupled.

The electrical device 2600 may include programmable circuitry 2602 (e.g., one or more processing devices). The programmable circuitry 2602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 2600 may include a memory 2604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 2604 may include memory that shares a die with the programmable circuitry 2602. This memory may be used as cache memory and may include embedded dynamic random access memory (eDRAM) or spin transfer torque magnetic random access memory (STT-MRAM).

In some examples, the electrical device 2600 may include a communication chip 2612 (e.g., one or more communication chips). For example, the communication chip 2612 may be configured for managing wireless communications for the transfer of data to and from the electrical device 2600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 2612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2612 may operate in accordance with other wireless protocols in other examples. The electrical device 2600 may include an antenna 2622 to facilitate wireless communications and/or to receive other wireless communications (such as AM or FM radio transmissions).

In some examples, the communication chip 2612 may manage wired communications, such as electrical, optical, or any other suitable communication protocols (e.g., the Ethernet). As noted above, the communication chip 2612 may include multiple communication chips. For instance, a first communication chip 2612 may be dedicated to shorter-range wireless communications such as Wi-Fi or Bluetooth, and a second communication chip 2612 may be dedicated to longer-range wireless communications such as global positioning system (GPS), EDGE, GPRS, CDMA, WiMAX, LTE, EV-DO, or others. In some examples, a first communication chip 2612 may be dedicated to wireless communications, and a second communication chip 2612 may be dedicated to wired communications.

The electrical device 2600 may include battery/power circuitry 2614. The battery/power circuitry 2614 may include one or more energy storage devices (e.g., batteries or capacitors) and/or circuitry for coupling components of the electrical device 2600 to an energy source separate from the electrical device 2600 (e.g., AC line power).

The electrical device 2600 may include a display 2606 (or corresponding interface circuitry, as discussed above). The display 2606 may include any visual indicators, such as a heads-up display, a computer monitor, a projector, a touchscreen display, a liquid crystal display (LCD), a light-emitting diode display, or a flat panel display.

The electrical device 2600 may include an audio output device 2608 (or corresponding interface circuitry, as discussed above). The audio output device 2608 may include any device that generates an audible indicator, such as speakers, headsets, or earbuds.

The electrical device 2600 may include an audio input device 2618 (or corresponding interface circuitry, as discussed above). The audio input device 2618 may include any device that generates a signal representative of a sound, such as microphones, microphone arrays, or digital instruments (e.g., instruments having a musical instrument digital interface (MIDI) output).

The electrical device 2600 may include GPS circuitry 2616. The GPS circuitry 2616 may be in communication with a satellite-based system and may receive a location of the electrical device 2600, as known in the art.

The electrical device 2600 may include any other output device 2610 (or corresponding interface circuitry, as discussed above). Examples of the other output device 2610 may include an audio codec, a video codec, a printer, a wired or wireless transmitter for providing information to other devices, or an additional storage device.

The electrical device 2600 may include any other input device 2620 (or corresponding interface circuitry, as discussed above). Examples of the other input device 2620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 2600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 2600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that provide optical links or waveguides between adjacent semiconductor dies in an IC package. Unlike known optical connections that rely on optical fibers that are mechanically aligned, the example waveguides disclosed herein are fabricated from polymers deposited using lithographic techniques. The deposition and etching of layers of material associated with lithography provides for much greater control and precision than is possible for the mechanical alignment processes used to position optical fibers. Furthermore, lithography fabrication processes can be scaled to produce any suitable number of waveguides at a single time (e.g., during the same deposition, etching, and/or lithographically patterning operations). Accordingly, examples disclosed herein enable large numbers of waveguides needed for the high bandwidth requirements of chip-to-chip communications needed in many modern integrated circuits with disaggregated dies. Disclosed systems, apparatus, articles of manufacture, and methods are accordingly directed to one or more improvement(s) in the operation of a machine such as a computer or other electronic and/or mechanical device.

Further examples and combinations thereof include the following:
Example 1 includes an apparatus comprising a package substrate, a first semiconductor die carried by the package substrate, the first semiconductor die including a first waveguide, the first waveguide including a first end associated with a first exterior surface of the first semiconductor die, and a second semiconductor die carried by the package substrate, the second waveguide including a second end associated with a second exterior of the second semiconductor die, the second waveguide optically coupled to the first waveguide.
Example 2 includes any preceding clause(s) of example 1, including a third waveguide optically coupling the first waveguide to the second waveguide, the third waveguide in a gap between the first semiconductor die and the second semiconductor die.
Example 3 includes any preceding clause(s) of any one or more of examples 1-2, wherein the third waveguide is supported by a filler material in the gap.
Example 4 includes any preceding clause(s) of any one or more of examples 1-3, wherein the filler material abuts at least one of the first semiconductor die or the second semiconductor die.
Example 5 includes any preceding clause(s) of any one or more of examples 1-4, wherein the filler material surrounds the third waveguide.
Example 6 includes any preceding clause(s) of any one or more of examples 1-5, wherein the third waveguide protrudes from and extends along a surface of the filler material, the surface faces away from the package substrate.
Example 7 includes any preceding clause(s) of any one or more of examples 1-6, wherein the third waveguide has a first refractive index, and the filler material has a second refractive index, the first refractive index greater than the second refractive index.
Example 8 includes any preceding clause(s) of any one or more of examples 1-7, wherein at least one side of an elongate length of the third waveguide is exposed to air.
Example 9 includes any preceding clause(s) of any one or more of examples 1-8, wherein a full perimeter of a cross-section of the third waveguide in a direction transverse to an elongate length of the third waveguide is exposed to surrounding air.
Example 10 includes any preceding clause(s) of any one or more of examples 1-9, wherein the first waveguide is included in a first array of first waveguides in the first semiconductor die, the second waveguide is included in a second array of second waveguides in the second semiconductor die, and the third waveguide is included in a third array of third waveguides in the gap between the first semiconductor die and the second semiconductor die.
Example 11 includes any preceding clause(s) of any one or more of examples 1-10, including a fourth waveguide in the gap between the first semiconductor die and the second semiconductor die, the fourth waveguide optically coupling a fifth waveguide in the first semiconductor die to a sixth waveguide in the second semiconductor die, the fourth waveguide closer to the package substrate than the third waveguide is to the package substrate.
Example 12 includes an apparatus comprising a first chip mounted on a package substrate, the first chip including a first waveguide, a second chip mounted on the package substrate, the second chip including a second waveguide, the second chip spaced apart from the first chip to define a space therebetween, and a third waveguide to bridge the space between the first and second chips to optically couple the first and second waveguides.
Example 13 includes any preceding clause(s) of example 12, including a first polymer filling at least part of the space between the first and second chips, the third waveguide including a second polymer different from the first polymer.
Example 14 includes any preceding clause(s) of any one or more of examples 12-13, wherein the first polymer has a first refractive index and the second polymer has a second refractive index greater than the first refractive index.
Example 15 includes any preceding clause(s) of any one or more of examples 12-14, wherein the first polymer substantially fills a portion of the space between the third waveguide and the package substrate.
Example 16 includes any preceding clause(s) of any one or more of examples 12-15, wherein the first chip includes a first surface facing away from the package substrate, the second chip includes a second surface facing away from the package substrate, and the first polymer includes a third surface facing away from the package substrate, the third surface flush with at least one of the first surface or the second surface.
Example 17 includes any preceding clause(s) of any one or more of examples 12-16, wherein the third waveguide is in direct contact with a first sidewall of the first chip and in direct contact with a second sidewall of the second chip, the first sidewall facing the second sidewall.
Example 18 includes an apparatus comprising a first semiconductor die, a second semiconductor die spaced apart from the first semiconductor die, a first material extending across a gap between the first and second semiconductor dies, the first material optically coupling first and second waveguides in the respective first and second semiconductor dies, and a second material different from the first material extending across the gap, the second material in contact with and supporting the first material.
Example 19 includes any preceding clause(s) of example 18, wherein the first material surrounds the second material.
Example 20 includes any preceding clause(s) of any one or more of examples 18-19, wherein at least a portion of the second material is uncovered and exposed to surrounding air.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a package substrate;
a first semiconductor die carried by the package substrate, the first semiconductor die including a first waveguide, the first waveguide including a first end associated with a first exterior surface of the first semiconductor die; and
a second semiconductor die carried by the package substrate, the second waveguide including a second end associated with a second exterior of the second semiconductor die, the second waveguide optically coupled to the first waveguide.

2. The apparatus of claim 1, including a third waveguide optically coupling the first waveguide to the second waveguide, the third waveguide in a gap between the first semiconductor die and the second semiconductor die.

3. The apparatus of claim 2, wherein the third waveguide is in direct contact with a first sidewall of the first semiconductor die and in direct contact with a second sidewall of the second semiconductor die, the first sidewall facing the second sidewall.

4. The apparatus of any one of claims 2 or 3, including a filler material in the gap.

5. The apparatus of claim 4, wherein the third waveguide is supported by the filler material in the gap.

6. The apparatus of claim 5, wherein the filler material abuts at least one of the first semiconductor die or the second semiconductor die.

7. The apparatus of claim 6, wherein the filler material abuts both the first semiconductor die and the second semiconductor die.

8. The apparatus of any one of claims 4-7, wherein the third waveguide has a first refractive index, and the filler material has a second refractive index, the first refractive index greater than the second refractive index.

9. The apparatus of any one of claims 4-8, wherein the filler material surrounds the third waveguide.

10. The apparatus of any one of claims 4-9, wherein the first semiconductor die has a first surface facing away from the package substrate, the second semiconductor die has a second surface facing away from the package substrate, and the filler material has a third surface facing away from the package substrate, the third surface flush with at least one of the first surface or the second surface.

11. The apparatus of any one of claims 2-10, wherein at least one side of an elongate length of the third waveguide is exposed to air.

12. The apparatus of any one of claims 4-8, wherein the third waveguide protrudes from and extends along a surface of the filler material, the surface faces away from the package substrate.

13. The apparatus of any one of claims 2-4, wherein a full perimeter of a cross-section of the third waveguide in a direction transverse to an elongate length of the third waveguide is exposed to surrounding air.

14. The apparatus of any one of claims 2-13, wherein the first waveguide is included in a first array of first waveguides in the first semiconductor die, the second waveguide is included in a second array of second waveguides in the second semiconductor die, and the third waveguide is included in a third array of third waveguides in the gap between the first semiconductor die and the second semiconductor die.

15. The apparatus of any one of claims 2-14, including a fourth waveguide in the gap between the first semiconductor die and the second semiconductor die, the fourth waveguide optically coupling a fifth waveguide in the first semiconductor die to a sixth waveguide in the second semiconductor die, the fourth waveguide closer to the package substrate than the third waveguide is to the package substrate.
